# EUROPEAN PATENT SPECIFICATION

(11) **EP 2 919 269 B1**
(45) Date of publication and mention of the grant of the patent: **19.07.2017**
(21) Application number: 15158510.6
(22) Date of filing: 10.03.2015
(51) Int. Cl.: H01L 27/146, H01L 31/115

(54) **Photosensor arrays for detection of radiation and process for the preparation thereof**
Photosensoranordnungen zur Detektion von Strahlung und Verfahren zur Herstellung davon
Réseaux de photodétecteurs pour la détection de rayonnement et son procédé de préparation

(30) Priority: 10.03.2014 US 201461950583 P
(43) Date of publication of application: 16.09.2015
(73) Proprietor: dpiX, LLC, Colorado Springs, DE 80916-3804 (US)
(72) Inventor: O'Rourke, Shawn, Colorado Springs, DE 80916-3804 (US); Weisfield, Richard L., Colorado Springs, DE 80916-3804 (US); Park, Byung-kyu, Colorado Springs, DE 80916-3804 (US); Yao, Bill, Colorado Springs, DE 80916-3804 (US); Park, Jungwon, Colorado Springs, DE 80916-3804 (US)
(74) Representative: Smaggasgale, Gillian Helen

(56) References cited:
- WO-A1-01/33634
- WO-A1-2011/099336
- CN-A- 102 916 085
- US-A1- 2012 061 578

## Description

### FIELD OF THE INVENTION

The present invention generally relates to semiconductor sensor devices, and more particularly to photosensor arrays, such as imaging arrays, for the detection of radiation elements, and related methods.

### BACKGROUND

Digital radiography is a form of X-ray imaging in which digital X-ray sensors are used instead of X-ray film. Among its potential advantages, digital radiography enables immediate image preview and availability, eliminates film processing steps, offers a wider dynamic range, and provides the ability to apply special image processing techniques that enhance overall display of the image.

Flat panel detectors (FPDs) have been proposed for use as a digital image capture device and amorphous silicon (α-Si) is a common material of construction for commercial FPDs proposed to-date. Such FPDs comprise pixels having switching elements such as thin film transistors and photoelectric conversion elements such as photodiodes arranged two-dimensionally. In addition to this, the array substrate generally has gate lines and bias lines that supply a voltage to the switching elements and data lines to read photovoltaic power of the photoelectric conversion elements. The switching element is provided at an intersection point of the gate line and the data line and the bias line is provided to intersect the pixel that is defined by the intersection of the gate line and the data line. See for example, U.S. Patent application serial nos. 2012/0033161 and 2013/0140568.
Digital X-ray detectors typically include a detector panel array that having a pixel array of light sensing photodiodes and switching thin film field-effect transistors (FETs) that convert light photons to electrical signals. A scintillator material deposited over the pixel array of photodiodes and FETs converts incident X-ray radiation photons received on the scintillator material surface to lower energy light photons. The pixel array of photodiodes and FETs converts the light photons to electrical signals. Alternatively, the detector panel array may convert the X-ray photons directly to electrical signals. The electrical signals are converted from analog signals to digital signals by a detector panel array interface which provides the digital signals to a processor to be converted to image data and reconstructed into an image of the features within the subject.

WO 2011/099336 discloses a semiconductor device including photosensor that is intended to be capable of imaging with high resolution. The semiconductor device includes the photosensor having a photodiode, a first transistor, and a second transistor. The photodiode generates an electric signal in accordance with the intensity of light. The first transistor stores charge in a gate thereof and converts the stored charge into an output signal. The second transistor transfers the electric signal generated by the photodiode to the gate of the first transistor and holds the charge stored in the gate of the first transistor. The first transistor has a back gate and the threshold voltage thereof is changed by changing the potential of the back gate.

The advent of digital X-ray detectors has brought enhanced workflow and high image quality to medical imaging relative to earlier analog radiographic imaging systems as well as offering image acquisition modes not available with film such as fluoroscopy. Digital X-ray detectors permit the acquisition of image data and reconstructed images for quicker viewing and diagnosis, and still allows for images to be readily stored and transmitted to consulting and referring physicians, radiologists and specialists like CR. One challenge with digital X-ray detectors, however, has been switching speeds, i.e., the speed of switching an imaging pixel on and off when integrated with a sensing element.

### SUMMARY

Among the various aspects of the present invention is the provision of photosensor arrays, and more particularly photosensors for the detection of radiation elements, and related methods. Further provided are methods of manufacturing a sensor element comprising metal oxide thin film transistors, used as the switching element, that are electrically connected to a photosensor element to provide readout operations with relatively fast switching and high mobility. In general, the photosensors comprise a thin film transistor having a metal oxide semiconductor channel, a photosensing element comprising amorphous silicon, and a hydrogen barrier structure, comprising a metal layer of a metal selected from the group consisting of Cr, Ti, W, Mo, Al, Nd-doped Al, Ta, TiN, and combinations thereof, separating the thin film transistor and the photosensing element to mitigate hydrogen poisoning of the metal oxide channel during high temperature processing steps, the metal layer having a thickness in the range of about 20 to about 300 nm. Advantageously, multiple metal oxide thin film transistors arranged in an amplification circuit in an imaging pixel increases the signal level keeping the noise relatively low. This allows the signal-to-noise ratio to be enhanced, which leads to the higher image quality of the imaging arrays and a lesser dose to the patient.

Briefly, therefore, one aspect of the present invention is a multilayer structure for use in a photosensor, the multilayer structure comprising a substrate, a thin film transistor comprising a metal oxide semiconductor channel and a photosensing element comprising hydrogenated amorphous silicon. The thin film transistor is electrically connected to the photosensing element, and the thin film transistor and photosensing element are on the substrate and separated by a hydrogen barrier structure.

Briefly, therefore, one aspect of the present invention is a photosensor pixel cell comprising a substrate, a pixel, a gate line, and a data line disposed on the substrate. The photosensor pixel comprises a metal oxide semiconductor thin film transistor connected to the gate line and the data line, a photosensing element comprising hydrogenated amorphous silicon, and a hydrogen barrier structure separating the thin film transistor and the photosensing element. The hydrogen barrier structure has a hydrogen diffusivity of less than 5 x 10⁻¹⁵ cm²/sec at 350 °C.

Another aspect of the present invention is a method of fabricating a photosensor pixel. The method comprises forming a photosensing element comprising hydrogenated amorphous silicon on a substrate, forming a thin film transistor having a metal oxide semiconductor channel on the substrate, and forming a hydrogen barrier structure separating the thin film transistor and the photosensing element. The hydrogen barrier structure has a hydrogen diffusivity of less than 5x10⁻¹⁵ cm²/sec at 350 °C.

Another aspect of the present invention is a solid-state image sensor comprising a substrate and a pixel array, a series of gate lines, and a series data lines disposed on the substrate. The pixel array comprises a population of photosensor pixels arranged in columns and rows. Each member of the pixel population comprises a metal oxide thin film transistor connected to one member of the gate line series and one member of the data line series, a photosensing element comprising hydrogenated amorphous silicon, and a hydrogen barrier structure separating the thin film transistor and the photosensing element. The hydrogen barrier structure typically has a hydrogen diffusivity of less than 5x10⁻¹⁵ cm²/sec at 350 °C.

A further aspect of the present invention is a method of fabricating a solid-state photosensor comprising a substrate and a pixel array, a gate line and a data line disposed on the substrate. The method comprises forming a gate line and a data line on a substrate, forming a photosensing element comprising a hydrogenated amorphous silicon layer on a substrate, forming a metal oxide thin film transistor on the substrate, connecting the metal oxide thin film transistor to the gate line and the data line, and forming a hydrogen barrier structure separating the metal oxide thin film transistor and the photosensing element, the hydrogen barrier structure having a hydrogen diffusivity of less than 5x10⁻¹⁵ cm²/sec at 350 °C.

Other objects and features will be in part apparent and in part pointed out hereinafter.

### BRIEF DESCRIPTION OF THE DRAWINGS

FIG. 1 is a schematic plan view of one embodiment of a photosensor of the present invention.
FIG. 2 is an enlarged view of a pixel of the photosensor of FIG. 2.
FIG. 3A is a schematic cross-sectional view of one alternative embodiment of a multilayer structure of the present invention.
FIG. 3B is a schematic cross-sectional view of one alternative embodiment of a multilayer structure of the present invention.
FIG. 3C is a schematic cross-sectional view of one alternative embodiment of a multilayer structure of the present invention.
FIG. 4A is a cross-sectional view of one alternative embodiment of a thin film transistor component of multilayer structure of the present invention.
FIG. 4B is a cross-sectional view of one alternative embodiment of a thin film transistor component of multilayer structure of the present invention.
FIG. 4C is a cross-sectional view of one alternative embodiment of a thin film transistor component of multilayer structure of the present invention.
FIG. 4D is a cross-sectional view of one alternative embodiment of a thin film transistor component of multilayer structure of the present invention.
FIG. 5 is a schematic cross-sectional view of one alternative embodiment of a multilayer structure of the present invention.
FIG. 6 is a schematic cross-sectional view of one alternative embodiment of a multilayer structure of the present invention.
FIG. 7 is a schematic cross-sectional view of one alternative embodiment of a multilayer structure of the present invention.
FIG. 8A is a schematic plan view of one embodiment of a photosensor of one pixel of the present invention.
FIG. 8B is a schematic cross-sectional view the pixel of FIG. 8A.

Corresponding reference characters indicate corresponding parts throughout the drawings. Additionally, relative thicknesses of the layers in the different figures do not represent the true relationship in dimensions. For example, the substrates are typically much thicker than the other layers. The figures are drawn only for the purpose to illustrate connection principles, not to give any dimensional information.

### ABBREVIATIONS AND DEFINITIONS

The following definitions and methods are provided to better define the present invention and to guide those of ordinary skill in the art in the practice of the present invention. Unless otherwise noted, terms are to be understood according to conventional usage by those of ordinary skill in the relevant art.

It will be understood that when an element or layer is referred to as being "on" or "connected to" another element or layer, it can be directly on or directly connected to the other element or layer, or intervening elements or layers may be present. In contrast, when an element is referred to as being "directly on" or "directly connected to" another element or layer, there are no intervening elements or layers present.

It will be understood that for the purposes of this disclosure, "at least one of" will be interpreted to mean any combination of the enumerated elements following the respective language, including combinations of multiples of the enumerated elements. For example, "at least one of X, Y, and Z" will be construed to mean X only, Y only, Z only, or any combination of two or more items X, Y, and Z (e.g. XYZ, XZ, YZ).

When introducing elements of the present invention or the embodiment(s) thereof, the articles "a," "an," "the," and "said" are intended to mean that there are one or more of the elements. The terms "comprising," "including," and "having" are intended to be inclusive and mean that there may be additional elements other than the listed elements.

Unless otherwise indicated, all numbers expressing quantities used in the specification and claims are to be understood as being modified in all instances by the term "about" or "approximately." Accordingly, unless indicated to the contrary, the numerical parameters set forth in the following specification and attached claims are approximations that may vary depending upon the desired properties sought to be obtained by the present invention. At the very least, and not as an attempt to limit the application of the doctrine of equivalents to the scope of the claims, each numerical parameter should at least be construed in light of the number of reported significant digits and by applying ordinary rounding techniques. Notwithstanding that the numerical ranges and parameters setting forth the broad scope of the invention are approximations, the numerical values set forth in the specific examples are reported as precisely as possible. If specific results of any tests are reported in the technical disclosure, any numerical value inherently can contain certain errors necessarily resulting from the standard deviation found in the respective testing measurements.

Recitation of ranges of values herein is merely intended to serve as a shorthand method of referring individually to each separate value falling within the range. Unless otherwise indicated herein, each individual value is incorporated into the specification as if it were individually recited herein. All methods described herein can be performed in any suitable order unless otherwise indicated herein or otherwise clearly contradicted by context. The use of any and all examples, or exemplary language (e.g. "such as", "in the case", "by way of example") provided herein is intended merely to better illuminate the invention and does not pose a limitation on the scope of the invention otherwise claimed. No language in the specification should be construed as indicating any non-claimed element essential to the practice of the invention.

### DETAILED DESCRIPTION

In general, the present disclosure is directed to multilayer structures that may be incorporated into photosensor devices such as X-ray detectors. The multilayer structure comprises a thin film transistor, a photosensing element electrically connected to the thin film transistor, and a hydrogen barrier, all supported by the substrate. The thin film transistor comprises a metal oxide channel, the photosensing element comprises an amorphous silicon layer, and the hydrogen barrier separates the thin film transistor and photosensing element. Functionally, the barrier structure mitigates hydrogen poisoning of the thin film transistor during any thermal processing of the multi-layer device. Additionally, metal oxide thin film array performance may also be degraded by prolonged exposure to atmospheric ambient and the present disclosure addresses strategies for both barriers to keep out the contaminant in the atmosphere but also barrier to seal in out-diffusion for stable thin film transistors under electrical stresses in operation. For example, in one embodiment the barrier structure provides a metallic "cap" over the metal oxide TFT dielectric to minimize the diffusion of moisture into the metal oxide channel.

In one embodiment, the multilayer structure may be a component of a digital X-ray detector including a pixel array comprising multiple pixels arranged in two dimensions, wherein each pixel includes a photosensing element and a transistor. The digital X-ray detector also includes a gate line for scanning a two-dimensional image, a data line coupled to each pixel in a second dimension, enable circuitry coupled to the transistor of each pixel for enabling readout of the photosensing element, and readout circuitry coupled to the photosensing element through the transistor of each pixel for reading out data from the photosensing element. The digital X-ray detector is configured to autonomously determine a start of an X-ray exposure while the enable circuitry maintains each transistor in an off state.

A multilayer structure comprising a thin film transistor, a photosensing element and a hydrogen barrier structure as described herein may be incorporated into a photosensor in any of a wide range of architectures. For example, in one embodiment the photosensing element may be a continuous layer across the active surface area of an array with pixelated charge-collecting electrodes. In another embodiment the array may comprise a population of individual pixelated photosensing elements ranging in dimension, depending upon the resolution needs of the application.

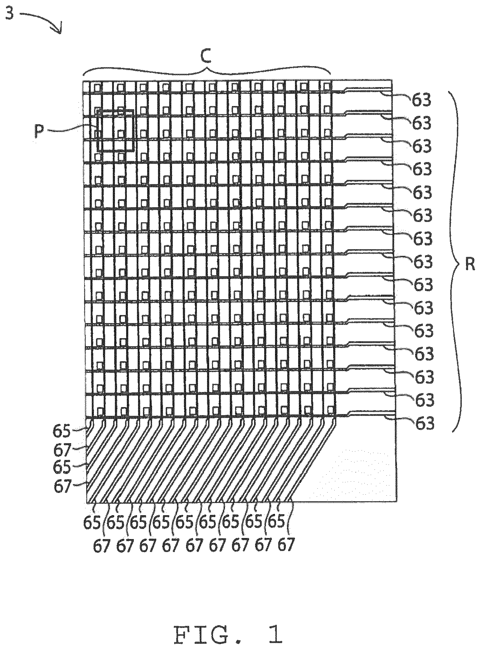

Referring now to Fig. 1, an exemplary photosensor 3 incorporating a multilayer structure in accordance with one embodiment of the present disclosure comprises substrate 25 and a two-dimensional array of pixels P disposed on substrate 25. Pixels P are arranged side-by-side, in a series of pixel columns C and a series of pixel rows R, with individual pixels P in the array being defined by areas partitioned by the intersection of gate lines 63 and data lines 67. As depicted in FIG. 1, data lines 67 are electrically connected to and separate columns of pixels and gate lines 63 are electrically connected to and separate rows of pixels, with the data lines and gate lines extending perpendicularly to each other. Bias lines 65 are electrically connected to columns of pixels and extend in parallel, and in alternating sequence, with data lines 67. Bias lines 65, data lines 67 and gate lines 63 extend to interconnect pads (not shown), respectively, for connecting the array of pixels P to terminals (not shown). For ease of illustration, in FIG. 1 photosensor 3 has 15 rows and 11 columns of pixels; in some embodiments, photosensor 3 may have tens, more typically hundreds to several thousands of rows and columns of pixels disposed on a photosensor substrate. In one embodiment, the pixels range in size from about 25 to about 1,000 micrometers, depending upon the resolution needs of the device. For example, in one such embodiment the pixels range in size from about 35 to about 500 micrometers. By way of further example, in one such embodiment the pixels range in size from about 50 to about 400 micrometers in size.

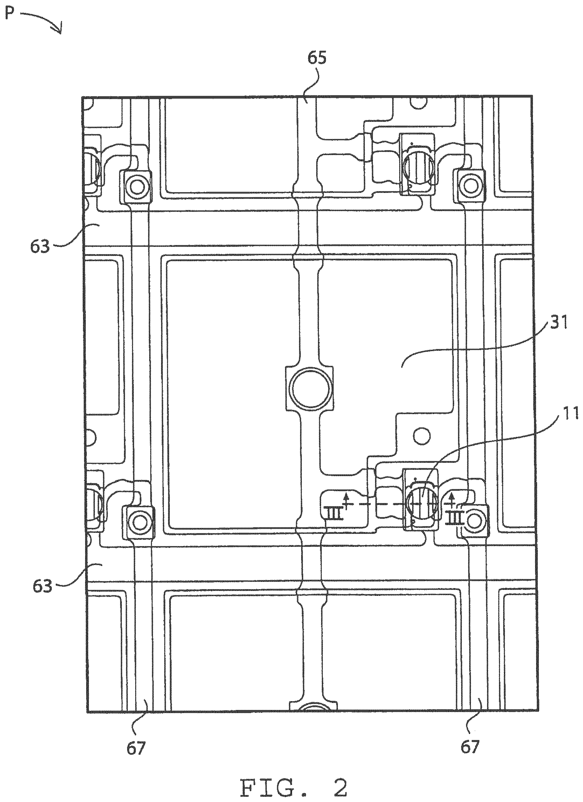

Referring now to FIG. 2, in one embodiment each pixel P comprises photosensing element 31, thin film transistor 11 and a hydrogen barrier structure (not shown) between photosensing element 31 and thin film transistor 11. Each pixel P is bounded by the intersections of gate lines 63 and data lines 67 and intersected by bias line 65. Thin film transistor 11 may comprise a thin film transistor having any the thin film architectures and materials of construction illustrated and described herein, photosensing element 31 may comprise any of the photosensing element types and materials of construction described herein, and the two may be arranged in a bottom-view, top-view or coplanar format. Additionally, the hydrogen barrier structure may comprise any of the materials of construction and have any of the dimensions previously described herein in connection with thin film transistors, photosensor elements and hydrogen barrier structures.

In operation, a gate terminal (not shown) inputs a driving signal to pixel P via gate line 63 from the outside, a data terminal (not shown) reads out charges detected in pixel P to the outside via data line 67, and a bias terminal (not shown) inputs an applied voltage from the outside to pixel P via the bias lines 65. For example, the thin film transistor 11 may be used as a switch for controlling whether the electrical signals from the photosensing element 31 are transmitted to the data lines 67 after scintillator light (not shown) is absorbed by photosensing element 31.

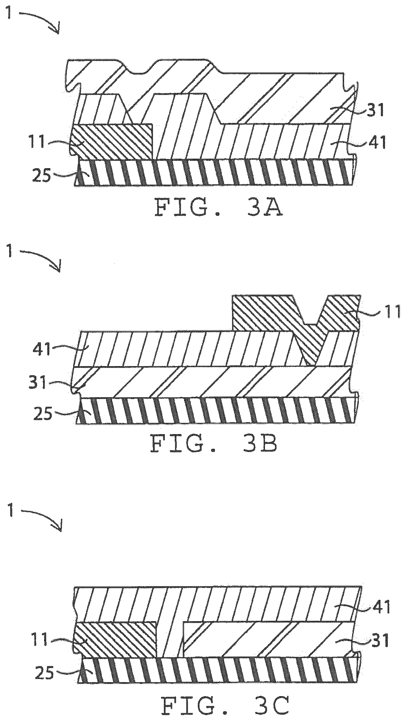

The multilayer structure of the present disclosure comprises a thin film transistor and a photosensing element in any of a wide range of architectures. FIGs. 3A - 3C depict several exemplary embodiments of a multilayer structure 1 comprising photosensing element 31 and thin film transistor 11 on substrate 25. In FIG. 3A, photosensing element 31 is on top of thin film transistor 11 (relative to substrate 25) with dielectric layer 41 in-between for electrical separation; this architecture is sometimes referred to as "top view architecture." In FIG. 3B, thin film transistor 11 is on top of photosensing element 31 (relative to substrate 25) with dielectric layer 41 in-between for electrical separation; this architecture, sometimes referred to as "bottom view architecture," provides certain advantages for mitigating hydrogen poisoning of the thin film transistor. In FIG. 3C, photosensing element 31 and thin film transistor 11 are coplanar (relative to substrate 25) and separated by dielectric layer 41, and share common metal routing (not shown); this architecture, sometimes referred to as "coplanar architecture" reduces the number of masks and steps required for fabrication relative to top view and bottom view architectures, thus potentially providing some cost advantages.

The thin film transistor may comprise any of a wide range of architectures. For example, in some embodiments the thin film transistor may have a horizontal, vertical, coplanar electrode, staggered electrode, top-gate, bottom-gate, single-gate, or double-gate architecture, to name a few. In certain embodiments, the thin film transistor may have a top gate or a bottom gate structure, using either the inverted -staggered or coplanar designs. For example, in one such embodiment the thin film transistor may be bottom gate structure with either an etch stopper or a back channel etch type structure. As used herein, a coplanar electrode configuration is intended to mean a transistor structure where the source and drain electrodes are positioned on the same side of the channel as the gate electrode. A staggered electrode configuration is intended to mean a transistor structure where the source and drain electrodes are positioned on the opposite side of the channel as the gate electrode.

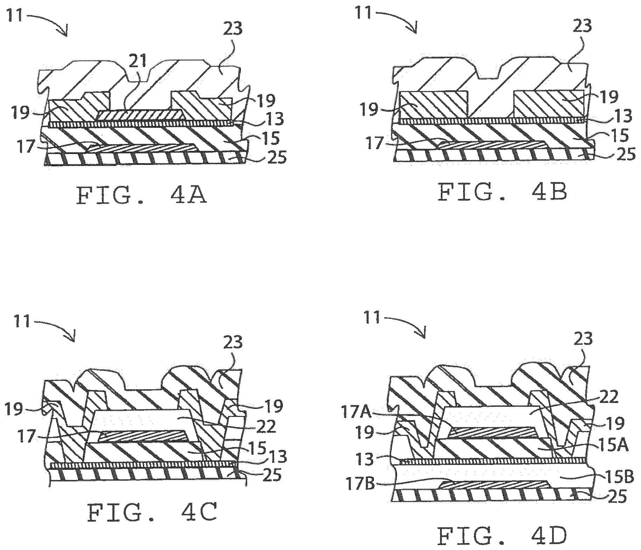

Exemplary embodiments of the thin film transistor are illustrated in FIGs. 4A - 4D. FIG. 4A illustrates a bottom gate island etch stopper thin film transistor 11 having metal oxide semiconductor channel 13, gate dielectric layer 15, gate electrode 17, source/drain 19, channel protection film 21, sealing dielectric layer 23 and substrate 25. FIG. 4B illustrates a bottom gate back channel etch thin film transistor 11 having metal oxide semiconductor channel 13, gate dielectric layer 15, gate electrode 17, source/drain 19, sealing dielectric layer 23 and substrate 25. FIG. 4C illustrates a top gate thin film transistor 11 having metal oxide semiconductor channel 13, gate dielectric layer 15, gate electrode 17, source/drain 19, drain protection film 22, sealing dielectric layer 23 and substrate 25. FIG. 4D illustrates a dual gate thin film transistor 11 having metal oxide semiconductor channel 13, gate dielectric layers 15A, 15B, gate electrodes 17A, 17B, source/drain 19, drain protection film 22, sealing dielectric layer 23 and substrate 25. In each of FIGS. 4A-1 D, the gate dielectric layer 15 is positioned between the gate electrode(s) 17, 17A, 17B and the source and drain electrodes 19 such that the gate dielectric layer(s) 15, 15A, 15B physically separate the gate electrode(s) 17, 17A, 17B from the source and the drain electrodes 19. Additionally, in each of the FIGS. 4A-4D, the source and the drain electrodes 19 are separately positioned thereby forming a region between the source and drain electrodes 19 for interposing the channel 13. Thus, in each of FIGS. 4A-4D, the gate dielectric layer(s) 15, 15A, 15B is/are positioned adjacent the channel 13, and physically separate the source and drain electrodes 19 from the gate electrode(s) 17, 17A, 17B. Additionally, in each of the FIGS. 4A-4D, channel 13 is positioned adjacent the gate dielectric layer(s) 15, 15A, 15B and is interposed between the source and drain electrodes 19.

Channel 13 comprises a semiconductor metal oxide material. In one embodiment, channel 13 comprises the oxide of one or multiple metals from group 12 and group 13 of the periodic table of elements. For example, in one embodiment the channel comprises an oxide of a group 12 or group 13 metal such as zinc oxide. By way of further example, in one such embodiment, the channel comprises a mixed metal oxide comprising two group 12 and/or group 13 elements such as zinc-tin oxide, indium-zinc oxide, zinc-gallium oxide, cadmium-gallium oxide, cadmium-indium oxide, or a combination thereof. By way of further example, in one such embodiment, the channel comprises a mixed metal oxide comprising three group 12 and/or group 13 metals; in one such embodiment, the mixed metal oxide may have the formula AₓBₓCₓOₓ where A is selected from the group of Zn, and Cd, B is selected from the group of Ga and In, C is selected from the group of Al, Zn, Cd, Ga, and In, O is oxygen, each x is independently a non-zero integer, and each of A, B, and C are different. Exemplary mixed metal oxides having the formula AₓBₓCₓOₓ include: aluminum-indium-zinc oxide, hafnium-indium-zinc oxide, indium-gallium-zinc oxide, cadmium-gallium-indium oxide, zinc-cadmium-gallium oxide, and zinc-cadmium-indium oxide. In other embodiments, the channel may be formed from a mixed metal oxide comprising four group 12 and/or group 13 metals; in one such embodiment, the mixed metal oxide may have the formula AₓBₓCₓDₓOₓ where A is selected from the group of Zn and Cd, B is selected from the group of Ga and In, C is selected from the group of Zn, Cd, Ga, and In, D is selected from the group of Zn, Cd, Ga, and In, O is oxygen, A, B, C and D are different and each x is independently a non-zero integer. That is, the value of "x" for each of the constituent elements may be different. Thus, in this embodiment, exemplary oxides include zinc-cadmium-gallium-indium oxide. In each of the foregoing embodiments, the metal oxide material may have any of a range of morphologies depending on composition, processing conditions, and other factors. The various morphological states can include amorphous states, and polycrystalline states. A polycrystalline state can include a single-phase crystalline state or a mixed-phase crystalline state.

Depending upon the application, channel 13 may have a range of compositions and configurations. For example, in one embodiment channel 13 has a substantially uniform semiconductor metal oxide composition throughout the channel. In an alternative embodiment, channel 13 is a multilayer structure. For example, in one such embodiment channel 13 is a multilayer channel comprising a first layer of a first semiconductor metal oxide composition and a second layer of a second semiconductor metal oxide composition (the first and second semiconductor metal oxide compositions being different). By way of further example, in one such embodiment, channel 13 may comprise three or more layers, each having a different semiconductor metal oxide composition. In yet another alternative embodiment, one or more layers of a monolayer or multilayer channel may have a graded oxygen concentration (the direction of the gradient being from the top to the bottom of the channel). For example, the first oxygen concentration may be 4 parts oxygen to equal atomic parts indium, gallium and zinc (*i.e*., 4:1:1:1) and the second oxygen concentration may have more than 4 parts oxygen to equal parts indium, gallium and zinc. (*i.e*., >4:1:1:1)

In general, channel 13 will typically have a thickness of at least about 5 nm. The thickness of the channel may vary depending on a range of factors including whether the channel material is amorphous or polycrystalline, and the device in which the channel is to be incorporated. Typically, the channel will have a thickness in the range of about 5 to 200 nm. In certain embodiments, for example, the channel may have a thickness of about 30 nm to about 100 nm. By way of further example, the channel may have a thickness in the range of about 40 to about 60 nm.

Source and drain electrodes 19 may comprise any of a range of materials conventionally used as source/drain electrodes in thin film transistors. For example, in one embodiment the source/drain electrodes may comprise a metal such as In, Sn, Ga, Zn, Al, Ti, Cr, Mo, Ag, Cu, Au, Pt, W, or Ni, and the like. By way of further example, in one embodiment the source and drain electrodes may comprise a layer of n-type doped In₂O₃, SnO₂, indium-tin oxide (ITO), or ZnO, and the like. In the various embodiments of the present disclosure, the source and drain electrodes may include transparent materials such that the various embodiments of the transistors may be made substantially transparent. Additionally, the source/drain electrodes may be a monolayer structure or a multi-layer structure such as a bi-layer, tri-layer or other multi-layer structure comprising multiple layers of such materials.

Gate dielectric 15, 15A, 15B (FIGs. 4A-D) may include various layers of different materials having insulating properties representative of gate dielectrics. Such materials can include tantalum pentoxide (Ta₂O₅), Strontium Titanate (ST), Barium Strontium Titanate (BST), Lead Zirconium Titanate (PZT), Strontium Bismuth Tantalate (SBT) and Bismuth Zirconium Titanate (BZT), silicon dioxide (SiO₂), silicon nitride (Si₃N₄), silicon oxynitride (SiON), magnesium oxide (MgO), aluminum oxide (Al₂O₃), hafnium(IV)oxide (HfO₂), zirconium(IV)oxide (ZrO₂), various organic dielectric material, and the like.

Referring again to FIGs. 2 and 3A-3C, photosensing element 31 comprises a hydrogenated amorphous silicon (*α*-Si) layer. The photosensing element may be, for example, a multi-layer amorphous silicon structure comprising a photosensitive intrinsic silicon layer with a doped amorphous silicon layer above and a doped amorphous silicon layer below the photosensitive intrinsic silicon layer faciliting lateral conduction and ohmic contact. For example, in one embodiment the photosensing element is a p-type/intrinsic silicon/n-type (PIN) photodiode comprising hydrogenated amorphous silicon, a n-type/intrinsic silicon /p-type (NIP) photodiode comprising amorphous silicon or a hydrogenated amorphous silicon metal-insulator semiconductor (MIS) sensor. Preferably, the side of the photosensing element to be exposed to radiation comprises tin oxide, zinc oxide, indium tin oxide (ITO), indium zinc oxide (IZO), antimony tin oxide (AZO), fluorine-doped tin oxide (FTO), aluminum-doped zinc oxide (AZO) or other suitable transparent conductive materials.

In one embodiment, photosensing element 31 comprises a vertical type photodiode, in which the electrodes are stacked over and below a hydrogenated amorphous silicon layer, respectively. For example, in one such embodiment photosensing element 31 is a PIN diode, comprising hydrogenated amorphous silicon. By way of further example, in one such embodiment the photosensing element comprises a PIN diode containing a n+ hydrogenated amorphous silicon layer for ohmic contact, a thicker layer of intrinsic amorphous silicon, and a layer of p-type amorphous silicon. These layers may be deposited sequentially and then patterned into an island with the n-layer having a thickness in the range of about 3 to about 50 nm, the intrinsic layer having a thickness in the range of about 500 to about 2,000 nm, and the p-layer having a thickness in the range of about 3 to about 50 nm. In general, the n-type dopant may be phosphorous (P) or other suitable n-type dopant or combination thereof and the p-type dopant may be boron (B) or other suitable p-type dopant or combination thereof. The p-type layer preferably is sufficiently thin to minimize any attenuation of incoming photons. A top diode contact may then be formed of a transparent conductive material such as indium tin oxide (ITO), tin oxide, zinc oxide, titanium oxide, n- or p-doped zinc oxide or zinc oxyfluoride over the amorphous silicon stack to permit light to pass to the intrinsic silicon of the photosensing element.

In one embodiment, photosensing element 31 comprises a MIS sensor comprising hydrogenated amorphous silicon. For example, in one such embodiment the MIS sensor comprises a dielectric layer formed over a charge collection electrode, a hydrogenated amorphous silicon layer formed over the dielectric, and an n+ semiconductor layer formed over the amorphous silicon layer. The dielectric layer may comprise, for example, SiON or SiN and may have a thickness in the range of about 5 to about 50 nm. The dielectric layer may comprise, for example, amorphous silicon and may have a thickness in the range of about 5 to about 1000 nm and the semiconductor layer may comprise n+ doped amorphous silicon and may have a thickness in the range of 5 to 50nm. At least one of the top and bottom electrodes is formed of a transparent conductive material such as indium tin oxide (ITO) to permit light to pass to the intrinsic silicon of the semiconductor layer.

Photosensing element 31 and thin layer transistor 11 are on the surface of substrate 25. The substrate may comprise a material such as silicon (or other semiconductor material), glass, plastic, or metal, and may even be an assembly of such materials. Thus, the substrate (or substrate assembly) may include such physical forms as sheets, films, and coatings, among others, and may be opaque or substantially transparent with or without layers or structures formed thereon, used in forming integrated circuits, and in particular thin-film transistors as described herein. In other embodiments, the substrate comprises a semiconductor wafer such as silicon wafers or other types of semiconductor wafer, e.g., gallium arsenide. In other embodiments, other substrates can also be used in the multilayer structures and methods of the present disclosure; these include, for example, fibers, wires, etc. In general, the films can be formed directly on the upper (or lower) surface of the substrate, or they can be formed on any of a variety of the layers (i.e., surfaces) as in a patterned wafer, for example.

The choice of architecture may be influenced by the application and the strategy for minimizing the interactions between the thin film transistor and the photosensing element. The metal oxide semiconductor channel of the thin film transistor and the α-Si based photosensing elements derive their performance from oxygen vacancy and hydrogen passivation of dangling bonds, respectively. These are somewhat incompatible requirements and the integration of a hydrogen barrier structure between the thin film transistor and the α-Si based photosensing elements facilitates integration and separate optimization of the two.

The hydrogen barrier structure may be any film or layer that blocks hydrogen from poisoning the thin film transistor in a heat-treatment step during fabrication of the multilayer structure. Hydrogen, for example, may be transported during the formation of the photosensing element or it may be desorbed from the photosensing element in a heat-treatment step that is subsequent to the formation of the photosensing element.

The hydrogen barrier structure comprises a metal layer of a metal such as Cr, Ti, W, Mo, Al, Nd-doped Al, Ta, TiN, or a combination thereof. In another embodiment, the hydrogen barrier structure comprises a layer of a dielectric such as silicon nitride, silicon oxide, a silicon oxynitride, aluminum oxide, aluminum nitride, aluminum oxynitride, titanium oxide, tantalum oxide, tantalum nitride, or a combination thereof. In one such embodiment, hydrogen barrier metal layers will have a thickness in the range of about 20 to about 300 nm and hydrogen barrier dielectric layers will have thickness in the range of about 1,000 to about 10,000 nm.

The hydrogen barrier structure may be a single-layer structure or a multi-layer structure comprising two or more of such layers in a stacked arrangement. For example, in one embodiment the hydrogen barrier structure comprises a stack of at least two layers, one being directly on the other, with one of the layers being a metal layer and the other being a dielectric layer. By way of further example, in one such embodiment the hydrogen barrier structure is a multilayer stack with one of the layers comprising one or more metals selected from the group consisting of Cr, Ti, W, Mo, Al, Nd-doped Al, Ta, or a combination thereof and another of said layers comprising silicon nitride, silicon oxide, a silicon oxynitride, aluminum oxide, aluminum nitride, aluminum oxynitride, titanium oxide, tantalum oxide, titanium nitride, tantalum nitride, or a combination thereof. In one embodiment, the hydrogen barrier structure is a multilayer stack comprising a dielectric layer and a metal layer directly on the dielectric layer. In certain embodiments, a multilayer stack of a metal layer and a dielectric layer are preferred because the metal layer provides an additional advantage of serving as a light shield during operation of the device, thereby reducing (or even blocking) light from reaching the thin film transistor. Such layers may be deposited according to methods known in the art for the deposition of metal layers and dielectric layers. For example, in one such embodiment the hydrogen barrier structure comprises an extrusion-coated dielectric comprising a polymer having affinity for hydrogen that can act as a sponge for hydrogen under subsequent hydrogen containing plasma environment to prevent hydrogen poisoning of the metal oxide TFT.

To mitigate hydrogen poisoning of the thin film transistor during thermal processing of a multilayer structure comprising the thin film transistor and the photosensing element on a substrate, the hydrogen barrier structure preferably has a hydrogen diffusivity of less than 5 x 10⁻¹⁵ cm²/sec at 350 °C. For example, in one embodiment the hydrogen barrier structure preferably has a hydrogen diffusivity of less than 2.5x10⁻¹⁵cm²/sec at 350 °C. By way of further example in such embodiment the hydrogen barrier structure preferably has a hydrogen diffusivity of less than 1x10⁻¹⁵cm²/sec at 350 °C.

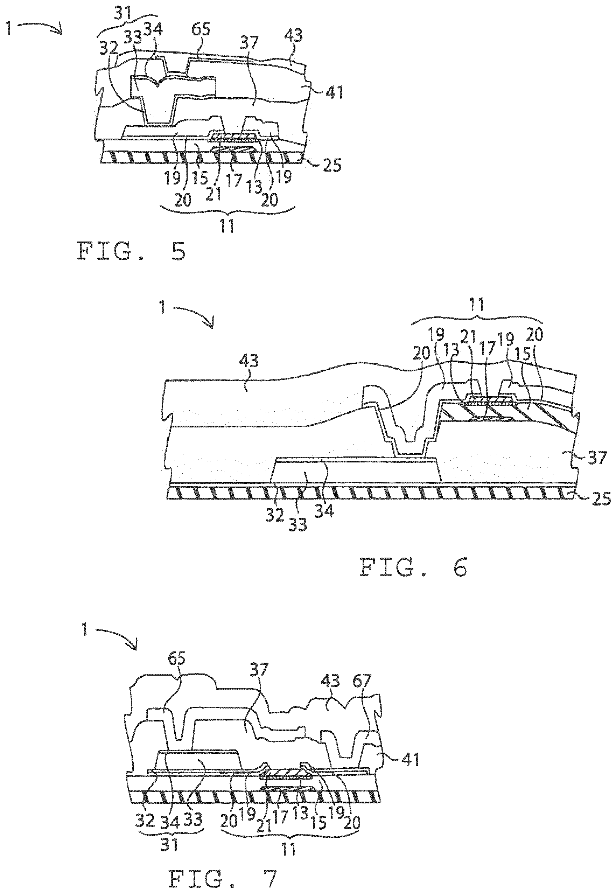

Referring now to FIG. 5, in one embodiment multilayer structure 1 has a top view architecture and comprises thin layer transistor 11, photosensing element 31, dielectric layer 37, dielectric layer 41, passivating layer 43, a hydrogen barrier structure (comprising layers 32 and 37) between photosensing element 31 and thin layer transistor 11, all supported by substrate 25. Thin layer transistor 11 is a bottom gate island etch stopper thin film transistor having metal oxide semiconductor channel 13, gate dielectric layer 15, gate electrode 17, source/drain 19, and channel protection film 21. Photosensing element 31 comprises a bottom diode contact 32, PIN diode 33 (comprising hydrogenated amorphous silicon as previously described) and top diode contact 34. Bottom diode contact 32 electrically connects PIN diode 33 to thin film transistor 11. Preferably, top diode contact 34 is formed of a transparent conductive material such as indium tin oxide (ITO) to permit light to pass into PIN diode 33 and bottom diode contact 32 is a metal layer comprising Cr, Ti, W, Mo, Al, Nd-doped Al, Ta, or a combination thereof. In this embodiment, bottom diode contact 32 and dielectric layer 37, in combination, constitute a multilayer hydrogen barrier structure having a hydrogen diffusivity of less than 5 x 10⁻¹⁵ cm²/sec at 350 °C. Advantageously, hydrogen barrier metal layer 65 also shields thin film transistor 11 from light during operation of a sensor comprising multilayer structure 1. Thin layer transistor 11 and photosensing element 31 are electrically connected to a gate line, bias line, and data line (not shown) for connecting multilayer structure 1 to terminals (not shown).

Referring now to FIG. 6, in one embodiment multilayer structure 1 has a bottom view architecture and comprises passivating layer 43, thin layer transistor 11, photosensing element 31 and a hydrogen barrier structure (as further defined below) between photosensing element 31 and thin layer transistor 11, all supported by substrate 25. Thin layer transistor 11 is a bottom gate island etch stopper thin film transistor having metal oxide semiconductor channel 13, gate dielectric layer 15, gate electrode 17, source/drain layers 19, 20, and channel protection film 21. Photosensing element 31 comprises a bottom diode contact 32, PIN diode 33 (comprising hydrogenated amorphous silicon as previously described) and top diode contact 34. Top diode contact 34 electrically connects PIN diode 33 to thin film transistor 11 via source/drain layers 19, 20. Preferably, bottom diode contact 32 is formed of a transparent conductive material such as indium tin oxide (ITO) to permit light to pass into PIN diode 33. In this embodiment, the hydrogen barrier structure is a multi-layer structure comprising gate dielectric 15, gate electrode 17 and dielectric layer 37; in combination, these layers have a hydrogen diffusivity of less than 5 x 10⁻¹⁵ cm²/sec at 350 °C. Thin layer transistor 11 and photosensing element 31 are electrically connected to a gate line, bias line, and data line (not shown) for connecting multilayer structure 1 to terminals (not shown).

Referring now to FIG. 7, in one embodiment multilayer structure 1 has a coplanar architecture and comprises thin layer transistor 11, photosensing element 31 and a hydrogen barrier structure (as further described below) between photosensing element 31 and thin layer transistor 11, all supported by substrate 25. Thin layer transistor 11 is a bottom gate island etch stopper thin film transistor having metal oxide semiconductor channel 13, gate dielectric layer 15, gate electrode 17, source/drain layers 19, 20, and channel protection film 21. Photosensing element 31 comprises a bottom diode contact 32, PIN diode 33 and top diode contact 34. Bottom diode contact 32 electrically connects PIN diode 33 to thin film transistor 11 via source/drain layers 19, 20. Preferably, top diode contact 34 is formed of a transparent conductive material such as indium tin oxide (ITO) to permit light to pass into PIN diode 33. In this embodiment, the hydrogen barrier structure is a multi-layer structure comprising source/drain layers 19, 20, dielectric layer 37 and channel protection film 21; in combination, these layers have a hydrogen diffusivity of less than 5 x 10⁻¹⁵ cm²/sec at 350 °C. Multilayer structure 1 further comprises dielectric layer 41, passivating layer 43, gate line 63, bias line 65 and data line 67. Advantageously, bias line 65 also shields thin film transistor 11 from light during operation of a sensor comprising multilayer structure 1.

The top view, bottom view and coplanar structures of FIGs. 5, 6 and 7 may be formed on glass, wafers or any flexible substrates 25 by means of physical vapor deposition, metal organic chemical vapor deposition (MOCVD), solution-based processes or other conventional techniques. The dielectric films and silicon-based films, doped or intrinsic may be deposited by chemical vapor deposition techniques, solution-based processes such as printing or extrusion coating, or other conventional techniques. In one embodiment, a high temperature anneal (e.g., 200 °C to 500 °C) is performed after a H₂-containing process step (for example, after a hydrogenated amorphous silicon deposition step, a silicon nitride deposition step, etc. In another alternative or additional embodiment, the TFT active layer is subjected to a surface treatment such as pre-annealing and plasma conditioning to fix back channel oxygen states prior to dielectric and photosensor deposition. After the films are deposited on the substrates, they receive surface cleaning processes followed by photolithography and etching processes to form devices and circuits.

In one embodiment, a photosensor array of the present disclosure contains a multi-layer dielectric structure (see, e.g., Fig. 5) with the upper layer having hydrogen barrier properties acting as a buffer to prevent hydrogen intrusion from the photo-sensing element to the metal oxide TFT matrix. Examplary dielectric materials include low density/high density SiO₂, low denstity SiO₂/high density SiN, low density SiO₂/planaring dielectric such as benzocyclobutene ("BCB")/high density SiN, etc.

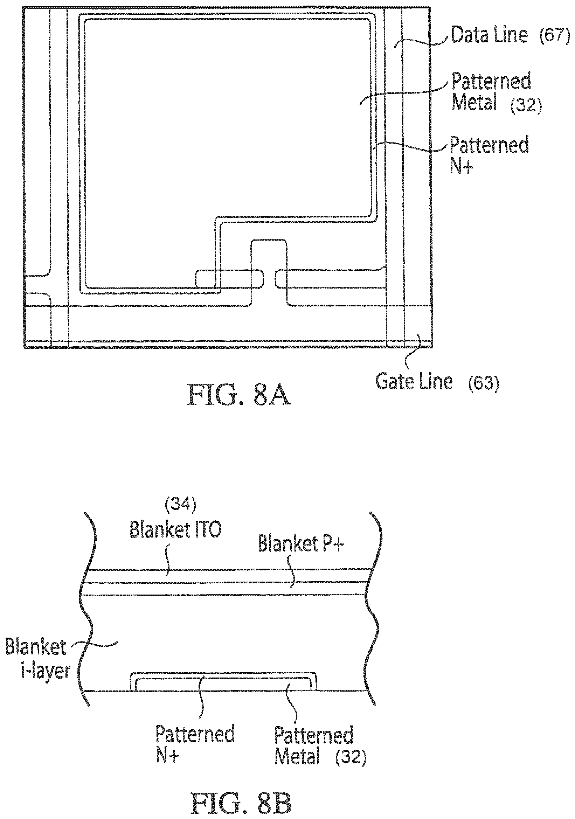

In one alternative embodiment, the photosensing element is a PIN diode comprising hydrogenated amorphous silicon wherein the PIN diode comprises a continuous layer of hydrogenated amorphous intrinsic silicon across the active surface area of a photosensor array (see Fig. 1). Referring now to Figs. 8A and 8B, in one such exemplary embodiment the photosensor array contains three blanket layers (*i.e*., layers that extend across the entire active surface of the photosensor array): a top diode contact 34 ("blanket ITO") formed of a transparent conductive material such as indium tin oxide (ITO), a p+ layer ("blanket p+") and a hydrogenated amorphous intrinsic silicon layer ("blanket i-layer"). Each pixel (see Fig. 8a) comprises a data line 67, a gate line 63, a bias line, a patterned n+ layer, and a bottom diode contact 32 ("patterned metal layer"). In this embodiment, the patterned n+ layer, blanket i-layer, and blanket p+ combine to form the PIN diode.

In one embodiment, the sensor imaging array comprises conducting metal layers serving one or more of the following five distinct electrical functions: (1) a gate metal that serves as the global gate lines for addressing the TFTs within the imaging array and which terminates at a contact pad on the edge of the array; (2) a data metal that serves as the global data lines for transferring signal to the read out electronics of the imaging array, (in the cases of the top view (FIG. 5) or bottom view (FIG. 6) architectures, the data metal also serves as the SD contact of the pixel TFT); (3) a bias metal that serves as either global lines and a backplane to provide and external reverse bias charge to the photodiode; (in the case of the co-planar architecture; the bias metal and the data metal can be the same); (4) a pixel electrode metal that serves as the pixellated collecting electrode of the sensor; and/or (5) SD contact metal layer to contact the TFT active channel. For example, in one such embodiment, the sensor imaging array comprises conducting metal layers serving at least two of the five distinct electrical functions enumerated in this paragraph. By way of further example, in one such embodiment, the sensor imaging array comprises conducting metal layers serving at least three of the five distinct electrical functions enumerated in this paragraph. By way of further example, in one such embodiment, the sensor imaging array comprises conducting metal layers serving at least four of the five distinct electrical functions enumerated in this paragraph. By way of further example, in one such embodiment, the sensor imaging array comprises conducting metal layers serving each of the five distinct electrical functions enumerated in this paragraph.

Having described the invention in detail, it will be apparent that modifications and variations are possible without departing the scope of the invention defined in the appended claims. Furthermore, it should be appreciated that all examples in the present disclosure are provided as non-limiting examples.

## Claims

1. A photosensor pixel cell comprising a substrate, a photosensor pixel, a gate line, and a data line disposed on the substrate, the photosensor pixel comprising a metal oxide thin film transistor connected to the gate line and the data line, a photosensing element comprising hydrogenated amorphous silicon, and a hydrogen barrier structure, comprising a metal layer of a metal selected from the group consisting of Cr, Ti, W, Mo, Al, Nd-doped Al, Ta, TiN, and combinations thereof, separating the metal oxide thin film transistor and the photosensing element, the metal layer having a thickness in the range of 20 to 300 nm, and the hydrogen barrier structure having a hydrogen diffusivity of less than 5 x 10⁻¹⁵ cm²/sec at 350 °C.

2. A method of fabricating a photosensor pixel, the method comprising forming a photosensing element comprising hydrogenated amorphous silicon on a substrate, forming a metal oxide thin film transistor on the substrate, and forming a hydrogen barrier structure as described in claim 1.

3. A solid-state image sensor comprising a substrate, a pixel array comprising a population of photosensor pixels arranged in columns and rows, a gate line, and a data line disposed on the substrate, each member of the pixel population comprising a metal oxide thin film transistor connected to the gate line and the data line, a photosensing element comprising hydrogenated amorphous silicon, and a hydrogen barrier structure as described in claim 1.

4. A method of fabricating a solid-state photosensor comprising a substrate, a pixel array comprising a population of pixels, a gate line and a data line disposed on the substrate, the method comprising
forming a gate line and a data line on a substrate, forming a photodiode comprising an hydrogenated amorphous silicon layer on a substrate, forming a metal oxide thin film transistor on the substrate, connecting the metal oxide thin film transistor to the gate line and the data line, and forming a hydrogen barrier structure as described in claim 1.

5. The photosensor pixel cell, solid-state image sensor, or method of any previous claim wherein the metal oxide thin film transistor comprises a source electrode, drain electrode, a gate dielectric and a channel, the channel comprising the oxide of one or metals from group 12 and group 13 of the periodic table of elements.

6. The photosensor pixel cell, solid-state image sensor, or method of claim 5 wherein the channel comprises a mixed metal oxide selected from the group consisting of zinc-tin oxide, indium-zinc oxide, zinc-gallium oxide, cadmium-gallium oxide, and cadmium-indium oxide.

7. The photosensor pixel cell, solid-state image sensor, or method of claim 5 wherein the channel comprises a mixed metal oxide having the formula AxBxCxOx where A is selected from the group of Zn, and Cd, B is selected from the group of Ga and In, C is selected from the group of Al, Zn, Cd, Ga, and In, O is oxygen, each x is independently a non-zero integer, and each of A, B, and C are different

8. The photosensor pixel cell, solid-state image sensor, or method of any preceding claim wherein the photosensing element comprises a multi-layer amorphous silicon structure comprising a photosensitive intrinsic silicon layer with a doped amorphous silicon layer above and a doped amorphous silicon layer below the photosensitive intrinsic silicon layer.

9. The photosensor pixel cell, solid-state image sensor, or method of claim 8 wherein the photosensing element is a p-type/intrinsic silicon/n-type (PIN) photodiode comprising hydrogenated amorphous silicon, a n-type/intrinsic silicon /p- type (NIP) photodiode comprising amorphous silicon or a hydrogenated amorphous silicon metal-insulator semiconductor (MIS) sensor.

10. The photosensor pixel cell, solid-state image sensor, or method of any preceding claim wherein a first side of the photosensing element is adapted for exposure to radiation and the first side comprises a layer of tin oxide, zinc oxide, indium tin oxide (ITO), indium zinc oxide (IZO), antimony tin oxide (AZO), fluorine-doped tin oxide (FTO), aluminum-doped zinc oxide (AZO) or other substantially transparent conductive materials.

11. The photosensor pixel cell, solid-state image sensor, or method of any preceding claim wherein the photosensing element is a PIN diode comprising a n+ hydrogenated amorphous silicon layer for ohmic contact, a thicker layer of intrinsic amorphous silicon, and a layer of p-type amorphous silicon.

12. The photosensor pixel cell, solid-state image sensor, or method of claim 11 wherein the n+ hydrogenated amorphous silicon layer, intrinsic amorphous silicon layer, and p-type amorphous silicon layers are deposited sequentially and patterned into an island with the n+-layer having a thickness in the range of about 3 to about 50 nm, the intrinsic layer having a thickness in the range of about 500 to about 2,000 nm, and the p-layer having a thickness in the range of about 3 to about 50 nm.

13. The photosensor pixel cell, solid-state image sensor, or method of claim 11 wherein the photosensing element comprises a top diode contact formed of a transparent conductive material over the amorphous silicon stack to permit light to pass to the intrinsic silicon of the photosensing element.

14. The photosensor pixel cell, solid-state image sensor, or method of any preceding claim wherein the hydrogen barrier structure is a multilayer stack comprising the metal layer and a dielectric layer.

15. The photosensor pixel cell, solid-state image sensor, or method of claim 14 wherein the dielectric layer comprises a dielectric selected from the group consisting of silicon nitride, silicon oxide, a silicon oxynitride, aluminum oxide, aluminum nitride, aluminum oxynitride, titanium oxide, tantalum oxide, tantalum nitride, and combinations thereof.

## Patentansprüche

1. Fotosensor-Pixelzelle, umfassend ein Substrat, einen Fotosensorpixel, eine Gate-Zeile und eine Datenzeile, die auf dem Substrat angeordnet sind, wobei der Fotosensorpixel einen mit der Gate-Zeile und der Datenzeile verbundenen Metalloxid-Dünnschichttransistor umfasst, ein hydriertes amorphes Silizium umfassendes Lichtabfühlelement, und eine Wasserstoffsperrstruktur, umfassend eine Metallschicht aus einem Metall, das aus der aus Cr, Ti, W, Mo, Al, Nd-dotiertem Al, Ta, TiN und Kombinationen derselben bestehenden Gruppe ausgewählt wird, die den Metalloxid-Dünnschichttransistor und das Lichtabfühlelement trennt, wobei die Metallschicht eine Dicke im Bereich von 20 bis 300 nm aufweist und die Wasserstoffsperrstruktur ein Wasserstoffdiffusionsvermögen von weniger als 5 x 10⁻¹⁵ cm²/s bei 350 °C aufweist.

2. Verfahren zum Herstellen eines Fotosensorpixels, wobei das Verfahren das Bilden eines hydriertes amorphes Silizium umfassenden Lichtabfühlelements auf einem Substrat, das Bilden eines Metalloxid-Dünnschichttransistors auf dem Substrat und das Bilden einer Wasserstoffsperrstruktur nach Anspruch 1 umfasst.

3. Festkörper-Bildsensor, umfassend ein Substrat, ein Pixel-Array, das eine Besetzung von in Spalten und Zeilen angeordneten Fotosensorpixeln umfasst, eine Gate-Zeile und eine Datenzeile, die auf dem Substrat angeordnet sind, wobei jedes Element der Pixelbesetzung einen mit der Gate-Zeile und der Datenzeile verbundenen Metalloxid-Dünnschichttransistor umfasst, ein hydriertes amorphes Silizium umfassendes Lichtabfühlelement und eine Wasserstoffsperrstruktur nach Anspruch 1.

4. Verfahren zum Herstellen eines Festkörper-Fotosensors, umfassend ein Substrat, ein eine Besetzung von Pixeln umfassendes Pixel-Array, eine Gate-Zeile und eine Datenzeile, die auf dem Substrat angeordnet sind, wobei das Verfahren Folgendes umfasst:
Bilden einer Gate-Zeile und einer Datenzeile auf einem Substrat, Bilden einer eine Schicht aus hydriertem amorphen Silizium umfassenden Fotodiode auf einem Substrat, Bilden eines Metalloxid-Dünnschichttransistors auf dem Substrat, Verbinden des Metalloxid-Dünnschichttransistors mit der Gate-Zeile und der Datenzeile, und Bilden einer Wasserstoffsperrstruktur nach Anspruch 1.

5. Fotosensor-Pixelzelle, Festkörper-Bildsensor oder Verfahren nach einem der vorangehenden Ansprüche, wobei der Metalloxid-Dünnschichttransistor eine Source-Elektrode, eine Drain-Elektrode, ein Gate-Dielektrikum und einen Kanal umfasst, wobei der Kanal das Oxid von einem oder Metallen der Gruppe 12 und der Gruppe 13 des Periodensystems der Elemente umfasst.

6. Fotosensor-Pixelzelle, Festkörper-Bildsensor oder Verfahren nach Anspruch 5, wobei der Kanal ein Mischmetalloxid umfasst, das aus der aus Zink-Zinn-Oxid, Indium-Zink-Oxid, Zink-Gallium-Oxid, Cadmium-Gallium-Oxid und Cadmium-Indium-Oxid bestehenden Gruppe ausgewählt wird.

7. Fotosensor-Pixelzelle, Festkörper-Bildsensor oder Verfahren nach Anspruch 5, wobei der Kanal ein Mischmetalloxid mit der Formel AxBxCxOx umfasst, wobei A aus der Gruppe aus Zn und Cd ausgewählt wird, B aus der Gruppe aus Ga und In ausgewählt wird, C aus der Gruppe aus Al, Zn, Cd, Ga und In ausgewählt wird, O Sauerstoff ist, jedes x unabhängig eine von null verschiedene ganze Zahl ist und A, B und C jeweils unterschiedlich sind.

8. Fotosensor-Pixelzelle, Festkörper-Bildsensor oder Verfahren nach einem der vorangehenden Ansprüche, wobei das Lichtabfühlelement eine mehrschichtige Struktur aus amorphem Silizium umfasst, die eine fotosensitive intrinsische Siliziumschicht mit einer dotierten amorphen Siliziumschicht über und einer dotierten amorphen Siliziumschicht unter der fotosensitiven intrinsischen Siliziumschicht umfasst.

9. Fotosensor-Pixelzelle, Festkörper-Bildsensor oder Verfahren nach Anspruch 8, wobei es sich bei dem Lichtabfühlelement um eine hydriertes amorphes Silizium umfassende PIN-Fotodiode (p-leitend/intrinsisches Silizium/n-leitend), eine amorphes Silizium umfassende NIP-Fotodiode (n-leitend/intrinsisches Silizium/p-leitend) oder einen Metall-Isolator-Halbleiter(MIS)-Sensor mit hydriertem amorphem Silizium handelt.

10. Fotosensor-Pixelzelle, Festkörper-Bildsensor oder Verfahren nach einem der vorangehenden Ansprüche, wobei ein erste Seite des Lichtabfühlelements zum Aussetzen an Strahlung angepasst ist und die erste Seite eine Schicht aus Zinnoxid, Zinkoxid, Indium-Zinn-Oxid (ITO), Indium-Zink-Oxid (IZO), Antimon-Zinn-Oxid (AZO), fluordotiertem Zinnoxid (FTO), aluminiumdotiertem Zinkoxid (AZO) oder anderen im Wesentlichen transparenten leitfähigen Materialien umfasst.

11. Fotosensor-Pixelzelle, Festkörper-Bildsensor oder Verfahren nach einem der vorangehende Ansprüche, wobei es sich bei dem Lichtabfühlelement um eine PIN-Diode handelt, die eine Schicht aus n+-hydriertem amorphem Silizium für ohmschen Kontakt, eine dickere Schicht aus intrinsischem amorphem Silizium und eine Schicht aus p-leitendem amorphem Silizium umfasst.

12. Fotosensor-Pixelzelle, Festkörper-Bildsensor oder Verfahren nach Anspruch 11, wobei die n+-hydrierte amorphe Siliziumschicht, die intrinsische amorphe Siliziumschicht und p-leitende amorphe Siliziumschichten sequenziell abgeschieden werden und zu einer Insel gemustert werden, wobei die n+-Schicht eine Dicke im Bereich von ungefähr 3 bis ungefähr 50 nm aufweist, die intrinsische Schicht eine Dicke im Bereich von ungefähr 500 bis ungefähr 2000 nm aufweist und die p-Schicht eine Dicke im Bereich von ungefähr 3 bis ungefähr 50 nm aufweist.

13. Fotosensor-Pixelzelle, Festkörper-Bildsensor oder Verfahren nach Anspruch 11, wobei das Lichtabfühlelement einen oberen Diodenkontakt umfasst, der aus einem transparenten leitfähigen Material über dem Stapel aus amorphem Silizium gebildet ist, um zuzulassen, das Licht zu dem intrinsischen Silizium des Lichtabfühlelements gelangt.

14. Fotosensor-Pixelzelle, Festkörper-Bildsensor oder Verfahren nach einem der vorangehenden Ansprüche, wobei es sich bei der Wasserstoffsperrstruktur um einen mehrschichtigen Stapel handelt, der die Metallschicht und eine Dielektrikumsschicht umfasst.

15. Fotosensor-Pixelzelle, Festkörper-Bildsensor oder Verfahren nach Anspruch 14, wobei die Dielektrikumsschicht ein Dielektrikum umfasst, das aus der aus Siliziumnitrid, Siliziumoxid, einem Siliziumoxynitrid, Aluminiumoxid, Aluminiumnitrid, Aluminiumoxynitrid, Titanoxid, Tantaloxid, Tantalnitrid und Kombinationen davon bestehenden Gruppe ausgewählt wird.

## Revendications

1. Cellule de pixel de photodétecteur comprenant un substrat, un pixel de photodétecteur, une ligne de gâchette, et une ligne de données disposées sur le substrat, le pixel de photodétecteur comprenant un transistor à couches minces en oxyde métallique connecté à la ligne de gâchette et à la ligne de données, un élément de photodétection comprenant du silicium amorphe hydrogéné, et une structure de barrière d'hydrogène, comprenant une couche métallique d'un métal sélectionné dans le groupe consistant en Cr, Ti, W, Mo, Al, Al dopé au Nd, Ta, TiN, et des combinaisons de ceux-ci, séparant le transistor à couches minces en oxyde métallique et l'élément de photodétection, la couche métallique ayant une épaisseur dans la plage de 20 à 300 nm, et la structure de barrière d'hydrogène ayant une diffusivité d'hydrogène de moins de 5 x 10⁻¹⁵ cm²/sec à 350 °C.

2. Procédé de fabrication d'un pixel de photodétecteur, le procédé comprenant la formation d'un élément de photodétection comprenant du silicium amorphe hydrogéné sur un substrat, la formation d'un transistor à couches minces en oxyde métallique sur le substrat, et la formation d'une structure de barrière d'hydrogène selon la revendication 1.

3. Détecteur d'image transistorisé comprenant un substrat, un réseau de pixels comprenant une population de pixels de photodétecteur agencée en colonnes et rangées, une ligne de gâchette, et une ligne de données disposées sur le substrat, chaque élément de la population de pixels comprenant un transistor à couches minces en oxyde métallique connecté à la ligne de gâchette et à la ligne de données, un élément de photodétection comprenant du silicium amorphe hydrogéné, et une structure de barrière d'hydrogène selon la revendication 1.

4. Procédé de fabrication d'un photodétecteur transistorisé comprenant un substrat, un réseau de pixels comprenant une population de pixels, une ligne de gâchette, et une ligne de données disposées sur le substrat, le procédé comprenant
la formation d'une ligne de gâchette et d'une ligne de données sur un substrat, la formation d'une photodiode comprenant une couche de silicium amorphe hydrogéné sur un substrat, la formation d'un transistor à couches minces en oxyde métallique sur le substrat, la connexion du transistor à couches minces en oxyde métallique à la ligne de gâchette et à la ligne de données, et la formation d'une structure de barrière d'hydrogène selon la revendication 1.

5. Cellule de pixel de photodétecteur, détecteur d'image transistorisé ou procédé selon l'une quelconque des revendications précédentes, dans lesquels le transistor à couches minces en oxyde métallique comprend une électrode de source, une électrode de drain, un diélectrique de gâchette et un canal, le canal comprenant l'oxyde d'un ou de plusieurs métaux du groupe 12 et du groupe 13 du tableau périodique des éléments.

6. Cellule de pixel de photodétecteur, détecteur d'image transistorisé ou procédé selon la revendication 5, dans lesquels le canal comprend un oxyde métallique mixte sélectionné dans le groupe consistant en oxyde de zinc-étain, oxyde d'indium-zinc, oxyde de zinc-gallium, oxyde de cadmium-gallium, et oxyde de cadmium-indium.

7. Cellule de pixel de photodétecteur, détecteur d'image transistorisé ou procédé selon la revendication 5, dans lesquels le canal comprend un oxyde métallique mixte de formule AxBxCxOx, où A est sélectionné dans le groupe de Zn, et Cd, B est sélectionné dans le groupe de Ga et In, C est sélectionné dans le groupe de Al, Zn, Cd, Ga et In, O est l'oxygène, et chaque x est indépendamment un entier non nul, et chacun de A, B et C est différent.

8. Cellule de pixel de photodétecteur, détecteur d'image transistorisé ou procédé selon l'une quelconque des revendications précédentes, dans lesquels l'élément de photodétection comprend une structure en silicium amorphe multicouche comprenant une couche de silicium intrinsèque photosensible entre une couche de silicium amorphe dopé supérieure et une couche de silicium amorphe dopé inférieure.

9. Cellule de pixel de photodétecteur, détecteur d'image transistorisé ou procédé selon la revendication 8 dans lesquels l'élément de photodétection est une photodiode de type P/silicium intrinsèque/type N (PIN) comprenant du silicium amorphe hydrogéné, une photodiode de type N/silicium intrinsèque/type P (NIP) comprenant du silicium amorphe ou un détecteur à métal-isolant-semiconducteur (MIS) en silicium amorphe hydrogéné.

10. Cellule de pixel de photodétecteur, détecteur d'image transistorisé ou procédé selon l'une quelconque des revendications précédentes, dans lesquels un premier côté de l'élément de photodétection est adapté pour être exposé à un rayonnement et le premier côté comprend une couche d'oxyde d'étain, d'oxyde de zinc, d'oxyde d'indium dopé à l'étain (ITO), d'oxyde d'indium dopé au zinc (IZO), d'oxyde d'antimoine dopé à l'étain (AZO), d'oxyde d'étain dopé au fluor (FTO), d'oxyde de zinc dopé à l'aluminium (AZO) ou d'autres matériaux conducteurs sensiblement transparents.

11. Cellule de pixel de photodétecteur, détecteur d'image transistorisé ou procédé selon l'une quelconque des revendications précédentes, dans lesquels l'élément de photodétection est une diode PIN comprenant une couche de silicium amorphe hydrogéné N+ de contact ohmique, une couche plus épaisse de silicium amorphe intrinsèque, et une couche de silicium amorphe de type P.

12. Cellule de pixel de photodétecteur, détecteur d'image transistorisé ou procédé selon la revendication 11, dans lesquels la couche de silicium amorphe hydrogéné N+, la couche de silicium amorphe intrinsèque, et les couches de silicium amorphe de type P sont déposées séquentiellement et reçoivent un motif d'îlot avec la couche N+ ayant une épaisseur dans la plage d'environ 3 à environ 50 nm, la couche intrinsèque ayant une épaisseur dans la plage d'environ 500 à environ 2000 nm, et la couche P ayant une épaisseur dans la plage d'environ 3 à environ 50 nm.

13. Cellule de pixel de photodétecteur, détecteur d'image transistorisé ou procédé selon la revendication 11, dans lesquels l'élément de photodétection comprend un contact de diode supérieur formé en un matériau conducteur transparent par-dessus la pile de silicium amorphe pour permettre le passage de la lumière jusqu'au silicium intrinsèque de l'élément de photodétection.

14. Cellule de pixel de photodétecteur, détecteur d'image transistorisé ou procédé selon l'une quelconque des revendications précédentes, dans lesquels la structure de barrière d'hydrogène est un empilement multicouche comprenant la couche métallique et une couche diélectrique.

15. Cellule de pixel de photodétecteur, détecteur d'image transistorisé ou procédé selon la revendication 14, dans lesquels la couche diélectrique comprend un diélectrique sélectionné dans le groupe consistant en nitrure de silicium, oxyde de silicium, oxynitrure de silicium, oxyde d'aluminium, nitrure d'aluminium, oxynitrure d'aluminium, oxyde de titane, oxyde de tantale, nitrure de tantale, et des combinaisons de ceux-ci.
